# FASCICULE DE BREVET EUROPEEN

(11) **EP 0 763 860 B1**
(45) Date de publication et mention de la délivrance du brevet: **14.11.2001**
(21) Numéro de dépôt: 96401918.6
(22) Date de dépôt: 09.09.1996
(51) Int. Cl.: H01L 39/24

(54) **Procédé de fabrication d'un conducteur gainé torsadé en supraconducteur à haute température critique**
Verfahren zum Herstellen eines umkleideten und verdrillten Hochtemperatur-Supraleiters
Method of making a sheathed and stranded high Tc superconductor

(30) Priorité: 14.09.1995 FR 9510764
(43) Date de publication de la demande: 19.03.1997
(73) Titulaire: Nexans, 75008 Paris (FR)
(72) Inventeur: Duperray, Gérard, 91290 La Norville (FR); Herrmann, Peter Friedrich, 91410 Corbreuse (FR); Beghin, Erick, 92100 Boulogne s/Seine (FR); Legat, Denis, 91090 Lisses (FR)
(74) Mandataire: Feray, Valérie

(56) Documents cités:
- EP-A- 0 503 525
- EP-A- 0 509 436
- EP-A- 0 638 942
- US-A- 4 611 390

## Description

L'invention porte sur un procédé de fabrication d'un conducteur gainé torsadé en supraconducteur à haute température critique.

Un tel conducteur torsadé est destiné en particulier aux applications en courant variable sous champ magnétique fort.

Il est déjà connu de fabriquer un conducteur gainé torsadé en supraconducteur à partir de monofilaments supraconducteurs ronds c'est à dire à section transversale circulaire ou ovale. On réalise une billette à section circulaire à partir d'un assemblage de monobrins ronds dans un tube métallique cylindrique. On étire la billette par passage dans une filière circulaire pour obtenir un multibrin rond. On torsade le multibrin et on lamine le multibrin torsadé avec des rouleaux jusqu'à obtenir la dimension souhaitée du conducteur gainé supraconducteur torsadé. Un tel procédé de fabrication est décrit dans le document EP 0 638 942 A.

Le but de l'invention est de proposer un autre procédé de fabrication d'un conducteur gainé torsadé en supraconducteur à haute température critique.

A cet effet, l'invention a pour objet un procédé de fabrication d'un conducteur gainé torsadé en supraconducteur à haute température critique, caractérisé en ce que le conducteur gainé est fabriqué à partir d'une billette réalisée par un assemblage de monobrins de section carrée dans un tube métallique de section carrée.

Il a été constaté qu'un multibrin obtenu après étirage de la billette à section carrée, par passage dans une filière à galets ou dans une filière à friction, supporte beaucoup mieux une opération de torsadage qu'un multibrin obtenu à partir d'une billette à section circulaire telle qu'indiquée ci-dessus. En particulier, le multibrin ainsi obtenu peut être torsadé avec un pas de torsadage plus court ce qui est particulièrement avantageux pour les applications en courant variable où il est nécessaire de rester, après laminage du multibrin torsadé, avec un pas de torsadage de quelques millimètres pour éviter le plus possible les pertes d'énergie. Des essais ont montré qu'un multibrin de section carrée obtenu après étirage dans une filière à galets peut être torsadé avec un pas de torsadage inférieur à 5mm alors qu'avec un tel pas de torsadage, le multibrin de section circulaire obtenu à partir d'une billette de section circulaire présente des fissures.

Avantageusement, la billette est étirée par passage dans une filière à galets pour obtenir un multibrin de section carrée, qui est torsadé avec un certain pas et laminé avec des rouleaux ayant un diamètre au moins dix fois supérieur au pas de torsadage jusqu'à obtenir la dimension souhaitée du conducteur gainé torsadé. Un tel procédé permet de réduire le temps de fabrication du conducteur gainé torsadé, par rapport au procédé connu exposé ci-dessus, du fait que la majeure partie de la réduction de diamètre par étirage est réalisée dans une filière à galets beaucoup plus coulante qu'une filière à friction circulaire. L'étirage dans une filière à galets permet en outre de mieux préserver, comparativement à une filière circulaire, la matière du tube métallique qui sert à réaliser la billette en raison des contraintes de friction moins importantes qu'elle engendre. Ainsi, il est possible de réaliser une billette avec un tube métallique d'une épaisseur relativement faible. Si ce tube est à base d'alliages d'argent, l'application du procédé selon l'invention permet d'obtenir une diminution notable des coûts de fabrication du conducteur gainé torsadé. En plus, l'étirage dans une filière à galets permet d'obtenir des interfaces métal/supraconducteur relativement planes. Il en résulte une qualité accrue de la texturation du conducteur gainé torsadé en supraconducteur. Les filaments supraconducteurs à section carrée restent bien séparés les uns des autres en conservant une section constante sans interruption des âmes supraconductrices et avec un maintien homothétique de l'assemblage.

La billette à section carrée peut être étirée dans une filière à friction pour obtenir un multibrin de section polygonale, notamment hexagonale si l'application le requiert avec l'inconvénient de prévoir un tube métallique d'épaisseur plus importante. Cependant ce multibrin présente encore une aptitude au torsadage comparable à celle du multibrin à section carrée. En variante, la billette est étirée d'abord dans une filière à galets et ensuite dans une filière à friction ce qui permet notamment de passer d'une section carrée à une section d'une autre géométrie, si l'application le requiert, par exemple à une géométrie polygonale et notamment hexagonale ou à une géométrie circulaire. Dans ce cas, le coefficient de réduction de section appliqué dans la filière à friction est de préférence bien inférieur à celui appliqué dans la filière à galets, c'est-à-dire que la section du multibrin à section carrée obtenu en sortie de la filière à galets est proche de la section finale du multibrin de section polygonale ou circulaire. Dans tous les cas, on conserve l'aptitude du multibrin au torsadage tout en préservant la matière du tube métallique.

Un exemple de réalisation du procédé selon l'invention est décrit ci-après plus en détail.

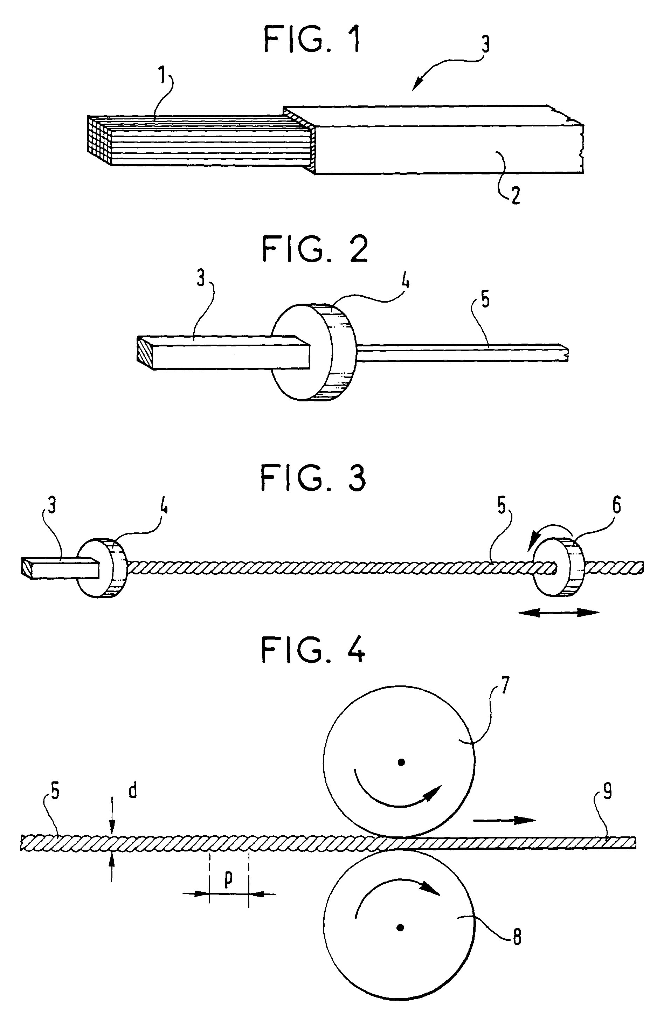

Les figures 1 à 4 illustrent les différentes étapes du procédé selon l'invention.

Dans ce qui suit, le terme carré doit être interprété comme sensiblement carré.

Figure 1, un certain nombre de monobrins 1 en supraconducteur sont empilés et assemblés dans un tube métallique 2, à section carrée, à base d'alliage d'argent ou d'un composite argent-alliage résistif, pour constituer une billette 3 à section carrée. A noter que les monobrins ont une section carrée, dans l'exemple de 1,2 par 1,2mm. Ils sont obtenus conformément au procédé décrit dans le document FR-A-2675620 à ceci près qu'aucun facteur de forme n'est appliqué au cours de l'étirage. La billette est constituée par exemple de 8 par 8 monobrins ayant la dimension indiquée ci-dessus et le tube 2 a une section carrée de 8 mm à l'intérieur et 10 mm à l'extérieur.

Figure 2, la billette 3 est étirée par passage dans une filière à galets 4 (représentée de façon stylisée) pour obtenir un multibrin 5 de section carrée, dans l'exemple de 1,6 par 1,6 mm. Au cours de l'étirage, la géométrie interne des monobrins est préservée, c'est-à-dire que les filaments restent bien séparés les uns des autres en gardant une section constante sans interruption des âmes supraconductrices.

Figure 3, le multibrin 5 en sortie de la filière à galets 4 est torsadé sous tension, avec un certain pas (dans l'exemple un pas de 5 mm). Ce torsadage s'accompagne d'un gonflement du multibrin au dépens de la longueur que l'on peut contrôler, dans une certaine mesure, grâce à la tension appliquée par déplacement du mors tournant d'extrémité 6. Dans le cas d'un multibrin ayant une section de 2,56 mm², la tension est réglée de façon à obtenir une augmentation de diamètre inférieure à 20%. Dans le cas d'exemple, le diamètre final du multibrin torsadé est environ de 2 mm.

Figure 4, le multibrin 5 torsadé est laminé par passage entre deux rouleaux 7 et 8 ayant un diamètre au moins dix fois supérieur au pas de torsadage p jusqu'à obtenir la dimension souhaitée du ruban gainé torsadé 9. Des essais concluants ont été effectués pour un multibrin torsadé d'un diamètre d d'environ 2,4 mm avec un pas de torsadage d'environ 5mm et des rouleaux ayant un diamètre de 250mm dans l'exemple considéré. Au cours du laminage de ce multibrin, on laisse le multibrin s'élargir jusqu'à 4 mm, puis ensuite on le lamine à largeur constante jusqu'à obtenir une section de 0,5 par 4 mm, soit un taux de réduction de section de 36% correspondant à un allongement de 1,57, le pas final du torsadage après laminage étant de 9,6 mm. Cette opération n'est possible que si le diamètre des rouleaux est grand devant le pas de torsadage p car sinon on observerait un détorsadage du multibrin. L'élargissement du multibrin en début de laminage permet de contrôler l'élongation du conducteur torsadé et donc l'augmentation du pas de torsadage. Dans l'application aux courants variables, il est souhaitable d'obtenir un conducteur en supraconducteur ayant un pas de torsadage de quelques millimètres.

A noter que l'étape de laminage peut être précédée d'une étape de calibrage en filière à friction (non représentée), pour conférer au multibrin une section d'une autre géométrie, par exemple polygonale et notamment hexagonale ou une section circulaire. La section circulaire est de nature à empêcher tout détorsadage du multibrin pendant le laminage. Le coefficient de réduction de section du multibrin dans la filière à friction devra rester toutefois très limité, environ 20%, c'est-à-dire bien inférieur à celui appliqué dans la filière à galets. En variante, la billette 3 peut aussi être directement étirée dans une filière à friction (non représentée) pour obtenir un multibrin de section polygonale et notamment hexagonale qui présente aussi de bonnes aptitudes au torsadage.

## Revendications

1. Un procédé de fabrication d'un conducteur gainé torsadé en supraconducteur à haute température critique, **caractérisé par** les étapes suivantes :
- on assemble des monobrins (1) de section carrée dans un tube métallique (2) de section carrée pour réaliser une billette (3) de section carrée,
- on étire la billette (3) par passage dans une filière pour obtenir un multibrin (5) de section carrée,
- on torsade le multibrin (5) avec un certain pas et,
- on lamine le multibrin torsadé jusqu'à obtenir la dimension souhaitée du conducteur gainé torsadé.

2. Le procédé selon la revendication 1, dans lequel la billette est étirée dans une filière à galets (4).

3. Le procédé selon la revendication 2, dans lequel on torsade le multibrin (5) de section carrée avec des rouleaux (7,8) ayant un diamètre au moins dix fois supérieur au pas de torsadage.

4. Le procédé selon la revendication 2, dans lequel la billette est étirée d'abord dans une filière à galets (4) et ensuite dans une filière à friction, le coefficient de réduction de section appliqué dans la filière à friction étant bien inférieur à celui appliqué dans la filière à galets (4).

5. Le procédé selon la revendication 4, dans lequel le coefficient de réduction de section appliqué dans la filière à friction est d'environ 20%.

6. Le procédé selon la revendication 2, dans lequel le multibrin est torsadé sous tension pour limiter l'augmentation de la section du multibrin à une valeur inférieure à 20%.

7. Le procédé selon la revendication 2, dans lequel le laminage est réalisé de façon à laisser d'abord s'élargir le multibrin jusqu'à une dimension déterminée, puis ensuite à garder constante cette dimension.

## Patentansprüche

1. Verfahren zur Herstellung eines umhüllten verdrillten Leiters aus Supraleiter mit hoher kritischer Temperatur, **gekennzeichnet durch** die folgenden Schritte:
- Zusammenfügen von Einzelsträngen (1) mit viereckigem Querschnitt in einem Metallrohr (2) mit viereckigem Querschnitt, um einen Bolzen (3) mit viereckigem Querschnitt zu bilden,
- Ziehen des Bolzens (3) **durch** Durchgang **durch** eine Ziehdüse, um einen Vielfachstrang (5) mit viereckigem Querschnitt zu bilden,
- Verdrillen des Vielfachstrangs (5) mit einer bestimmten Steigung und
- Walzen des verdrillten Vielfachstrangs, bis die gewünschte Abmessung des umhüllten verdrillten Leiters erreicht ist.

2. Verfahren nach Anspruch 1, bei dem der Bolzen in einer Rollenziehdüse (4) gezogen wird.

3. Verfahren nach Anspruch 2, bei dem der Vielfachstrang (5) von viereckigem Querschnitt mit Rollen (7, 8) verdrillt wird, die einen Durchmesser von wenigstens dem Zehnfachen der Verdrillungssteigung haben.

4. Verfahren nach Anspruch 2, bei dem der Bolzen zunächst in einer Rollenziehdüse (4) und anschließend in einer Reibziehdüse gezogen wird, wobei der in der Reibziehdüse angewendete Querschnittsverringerungskoeffizient kleiner als der in der Rollenziehdüse angewendete ist.

5. Verfahren nach Anspruch 4, bei dem der in der Reibdüse angewendete Querschnittsverringerungskoeffizient ca. 20% beträgt.

6. Verfahren nach Anspruch 2, bei dem der Mehrfachstrang unter Spannung verdrillt wird, um die Querschnittszunahme des Vielfachstrangs auf einen Wert von unter 20% zu begrenzen.

7. Verfahren nach Anspruch 2, bei dem das Walzen so durchgeführt wird, dass zunächst eine Verbreiterung des Mehrfachstrangs bis auf eine gegebene Abmessung zugelassen wird und diese Abmessung dann konstant gehalten wird.

## Claims

1. A method of manufacturing a sheathed twisted superconductor having a high critical temperature, **characterized by** the following steps:
- square cross-section single strands (1) are assembled in a square cross-section metal tube (2) to produce a square cross-section billet (3),
- the billet (3) is drawn by passing it through a die to obtain a square cross-section multistrand (5),
- the multistrand (5) is twisted with a particular lay, and
- the twisted multistrand is rolled to the required dimensions of the twisted sheathed conductor.

2. The method according to claim 1, wherein the billet is drawn through a roller die (4).

3. The method according to claim 2, wherein the square cross-section multistrand 5 is twisted with rollers (7, 8) having a diameter at least ten times greater than the twist lay.

4. The method according to claim 2, wherein the billet is drawn firstly through a roller die (4) and then through a friction die, the cross-section reduction coefficient applied at the friction die being much less than that applied at the roller die (4).

5. The method according to claim 4, wherein the cross-section reduction coefficient applied at the friction die is approximately 20%.

6. The method according to claim 2, wherein the multistrand is twisted under tension to limit the increase in the cross-section of the multistrand to a value less than 20%.

7. The method according to claim 2, wherein the rolling is carried out in such a manner as firstly to allow the multistrand to widen to a particular dimension and then to keep that dimension constant.
